# EUROPÄISCHE PATENTSCHRIFT

(11) **EP 3 335 250 B1**
(45) Veröffentlichungstag und Bekanntmachung des Hinweises auf die Patenterteilung: **15.12.2021**
(21) Anmeldenummer: 16730355.1
(22) Anmeldetag: 16.06.2016
(51) Int. Cl.: H01L 41/047, H01L 41/293

(54) **HERSTELLUNGSVERFAHREN ZUM HERSTELLEN EINES ELEKTROMECHANISCHEN AKTORS**
PRODUCTION METHOD FOR PRODUCING AN ELECTROMECHANICAL ACTUATOR
PROCÉDÉ DE FABRICATION D'UN ACTIONNEUR ÉLECTROMÉCANIQUE

(30) Priorität: 10.08.2015 DE 102015215204
(43) Veröffentlichungstag der Anmeldung: 20.06.2018
(73) Patentinhaber: Vitesco Technologies GmbH, 93055 Regensburg (DE)
(72) Erfinder: HEINZE, Thomas, 09212 Limbach-Oberfrohna (DE); HAUBOLD, Jörg, 09212 Limbach-Oberfrohna (DE); KREISSIG, Udo, 09114 Chemnitz (DE); LENK, Andreas, 01728 Bannewitz / OT Possendorf (DE); MEINER, Andreas, 09235 Burkhardtsdorf (DE)
(86) Internationale Anmeldenummer: PCT/EP2016/063851
(87) Internationale Veröffentlichungsnummer: WO 2017/025228

(56) Entgegenhaltungen:
- EP-A1- 1 675 190
- DE-A1- 10 153 770
- DE-A1-102005 034 904
- DE-A1-102008 027 115
- DE-A1-102012 207 598
- DE-B3-102006 003 070

## Beschreibung

Die Erfindung betrifft ein Herstellungsverfahren zum Herstellen eines elektromechanischen Aktors.

Elektromechanische Aktoren werden häufig, beispielsweise in Form von Piezostapeln, als Betätigungselemente verwendet, zum Beispiel in Einspritzventilen der verschiedensten Motortypen für Kraftfahrzeuge.

Solche elektromechanischen Aktoren weisen zumeist eine Mehrzahl von Piezokeramikschichten auf, die beim Anlegen eines elektrischen Feldes mit einer Längenausdehnung reagieren, und umfassen zudem eine Mehrzahl von Elektrodenschichten, wobei Piezokeramikschichten und Elektrodenschichten alternierend entlang einer Längsachse aufeinander gestapelt angeordnet sind. Zumeist wird ein solcher Stapel an zwei sich gegenüberliegenden Seitenflächen elektrisch kontaktiert, um die Elektrodenschichten in dem Stapel ansteuern zu können, sodass sich ein elektrisches Feld innerhalb des Stapels ausbildet, auf das die Piezokeramikschichten durch Ausdehnung reagieren.

Um das elektrische Feld ausbilden zu können, werden zwei benachbarte Elektrodenschichten mit unterschiedlichen Potentialen angesteuert, das heißt die Kontaktierung nach außen endet an unterschiedlichen Kontaktierungsanschlüssen. Um diese unterschiedliche Kontaktierung realisieren zu können, ist es beispielsweise bekannt, nur jede zweite Elektrodenschicht bis an die jeweilige Seitenfläche heranzuführen, während sich die jeweils andere Elektrodenschicht nicht bis zu dieser Seitenfläche hin erstreckt.

Es ist jedoch auch bekannt, alle Elektrodenschichten allseitig bis an die Seitenflächen des Stapels heranzuführen, was große Vorteile hinsichtlich der Betätigung, Raumbeanspruchung und des gesamten Betriebsverhaltens des elektromechanischen Aktors hat. Solche Stapel, bei denen sämtliche Elektrodenschichten bis an die Seitenflächen des Stapels herangeführt sind, werden als sogenannte vollaktive Stapel bezeichnet. Hier ist jedoch die elektrische Kontaktierung der jeweiligen Elektrodenschichten schwieriger, da eine Isolierung jeder zweiten Elektrodenschicht von einer Außenkontaktierung schwieriger umzusetzen ist. Beispielsweise wird bei solchen Stapelaufbauten eine Isolationsschicht verwendet, die dann selektiv entfernt wird, um jede zweite Elektrodenschicht gezielt zu kontaktieren.

In DE 10 2006 003 070 B3 und DE 10 2012 207 598 A1 ist beispielsweise beschrieben, dass zur Kontaktierung der Elektrodenschichten in einem entsprechenden Stapel die Isolationsschicht an vorbestimmten Positionen entfernt wird.

Eine solche Isolationsschicht an Seitenflächen des Stapels weist zumeist keine kontinuierliche Schichtdicke auf, sondern hat, insbesondere wenn spezielle Lacke als Isolationsschichten verwendet werden, über die Seitenflächen des Stapels hinweg eine schwankende Schichtdicke. Dadurch besteht die Problematik, dass Elektrodenschichten, die unter einer größeren Schichtdicke der Isolationsschicht angeordnet sind, möglicherweise nicht vollständig freigelegt werden und so eine Kontaktierung nicht zuverlässig möglich ist. Gleichzeitig können Elektrodenschichten, die unter Isolationsschichtbereichen mit einer geringen Schichtdicke liegen, durch einen zu starken Abtrag der Isolationsschicht ihrerseits beschädigt werden, was ebenfalls unerwünscht ist.

Bislang ist es daher offen, wie es gelingt, die Elektrodenschichten trotz einer schwankenden Schichtdicke der Isolationsschicht zuverlässig freizulegen, ohne dabei die freizulegende Elektrodenschicht oder benachbarte Piezokeramikschichten zu beschädigen.

Aufgabe der Erfindung ist es daher, ein in dieser Hinsicht verbessertes Herstellungsverfahren vorzuschlagen.

Diese Aufgabe wird gelöst mit einem Herstellungsverfahren mit der Merkmalskombination des Anspruches 1.

Vorteilhafte Ausgestaltungen der Erfindung sind Gegenstand der abhängigen Ansprüche.

Bei einem Herstellungsverfahren zum Herstellen eines elektromechanischen Aktors wird zunächst ein als Stapel ausgebildetes elektrisches Bauelement bereitgestellt, das aus einer Mehrzahl von Piezokeramikschichten und aus einer Mehrzahl von Elektrodenschichten gebildet ist, die entlang einer Längsachse des Stapels abwechselnd übereinander gestapelt sind. Dann wird auf wenigstens eine parallel zu der Längsachse angeordnete Seitenfläche des Stapels eine Isolationsschicht aufgebracht, und zwar derart, dass an der Seitenfläche die Elektrodenschichten und die Piezokeramikschichten von der Isolationsschicht bedeckt sind. Darauffolgend wird wenigstens eine der Elektrodenschichten an der Seitenfläche des Stapels durch lokales Abtragen eines der freizulegenden Elektrodenschicht benachbarten, lokal begrenzten Isolationsschichtbereiches freigelegt. Dazu wird zunächst eine Schichtdicke des abzutragenden, lokal begrenzten Isolationsschichtbereiches senkrecht zu der Längsachse erfasst, und daraufhin eine Abtragungsrate zum Abtragen des Isolationsschichtbereiches der erfassten Schichtdicke des abzutragenden Isolationsschichtbereiches lokal begrenzt eingestellt.

Bei dem Herstellungsverfahren wird demgemäß die Schichtdicke des Isolationsschichtbereiches, der sich direkt neben der Elektrodenschicht, die freigelegt werden soll, befindet, vermessen. Mithilfe dieser Information kann eine Abtragungseinrichtung in ihren Abtragungsparametern, das heißt insbesondere in der Abtragungsrate, so eingestellt werden, dass nur die vermessene Schichtdicke des Isolationsschichtbereiches abgetragen wird. Dadurch wird die darunter liegende Elektrodenschicht zuverlässig freigelegt, jedoch nicht beschädigt, und auch die benachbart zu der freigelegten Elektrodenschicht angeordneten Piezokeramikschichten nur in geringem Maße oder sogar gar nicht beschädigt.

Unter "lokal begrenzt" soll verstanden werden, dass es sich um einen Bereich der Isolationsschicht handelt, der direkt benachbart zu der Elektrodenschicht angeordnet ist, die freigelegt werden soll. Entlang der Längsachse des Stapels erstreckt sich dieser Isolationsschichtbereich maximal bis zu 30% in die der freizulegenden Elektrodenschicht benachbarten Piezokeramikschichten bezüglich ihrer Dicke entlang der Längsachse des Stapels.

Da die Abtragungsrate ebenfalls lokal begrenzt eingestellt wird, können Bereiche, in denen die Schichtdicke der Isolationsschicht relativ groß ist, zuverlässig von der Isolationsschicht befreit werden, während andere Bereiche, in denen die Schichtdicke der Isolationsschicht besonders klein ist, im Bereich der Piezokeramikschichten und der Elektrodenschichten nicht beschädigt werden. Das heißt bei Isolationsschichten mit stark schwankender Schichtdicke, wie sie für üblicherweise verwendete Lacke typisch ist, wird ein Abtragungsverfahren mit einer lokal modulierbaren Abtragungsrate eingesetzt, sodass die lokale Abtragungsrate an die lokale Schichtdicke angepasst werden kann. Die Parameter, die die Abtragungsrate bestimmen, werden örtlich aufgelöst, das heißt an jedem Ort, an dem abgetragen werden soll, auf die dort vorliegende Schichtdicke der Isolationsschicht angepasst.

Bei dem bereitgestellten Stapel handelt es sich vorzugsweise um einen vollaktiven Stapel, bei dem sämtliche Elektrodenschichten vorteilhaft bis an alle Seitenflächen des Stapels herangeführt sind.

In vorteilhafter Ausgestaltung werden bei dem Herstellungsverfahren die Schichtdicken mehrerer lokal begrenzter Isolationsschichtbereiche auf der Seitenfläche schrittweise einzeln erfasst und die mehreren Isolationsschichtbereiche schrittweise einzeln abgetragen, wobei das schrittweise Erfassen und das schrittweise Abtragen der einzelnen Schichtdicken unmittelbar aufeinanderfolgend durchgeführt wird. Das bedeutet, dass die nötige lokale Schichtdickeninformation vorzugsweise simultan zu einer schrittweisen Abtragung der Isolationsschicht ermittelt wird.

Beispielsweise können die Schichtdicken bei einer solchen simultanen Arbeitsweise mittels der sogenannten Plasmaspektroskopie erfasst werden. Dabei wird mit einer elektromagnetischen Strahlung die Isolationsschicht in dem Isolationsschichtbereich abgetragen, wobei ein Plasma aus dem abgetragenen Material entsteht. Das optische Spektrum des Plasmaleuchtens beinhaltet Spektrallinien, durch die man auf das Material schließen kann. Sobald demgemäß die elektromagnetische Strahlung auf die Piezokeramikschichten bzw. die Elektrodenschichten trifft, ändern sich die Spektrallinien, sodass erkannt werden kann, an welchem Punkt das Abtragungsverfahren abgebrochen werden muss, um zu verhindern, dass die Piezokeramikschichten bzw. die Elektrodenschichten beschädigt werden.

In einer alternativen Ausgestaltung werden die Schichtdicken mehrerer lokal begrenzter Isolationsschichtbereiche auf der Seitenfläche des Stapels schrittweise erfasst und die mehreren Isolationsschichtbereiche schrittweise abgetragen, wobei zunächst alle Schichtdicken der mehreren Isolationsschichtbereiche schrittweise ohne Abtragungsschritte dazwischen erfasst werden und dann das Abtragen der mehreren Isolationsschichtbereiche schrittweise ohne Erfassungsschritte dazwischen durchgeführt wird.

Das bedeutet, sämtliche Schichtdicken der Isolationsschichtbereiche auf einer Seitenfläche des Stapels, alternativ auch auf allen Seitenflächen des Stapels, werden vollständig vermessen und beispielsweise zwischengespeichert, und dann das Abtragen der einzelnen Isolationsschichtbereiche direkt in einem Zug durchgeführt.

Vorteilhaft wird die Schichtdicke des abzutragenden Isolationsschichtbereiches zerstörungsfrei erfasst, wobei die Schichtdicke insbesondere optisch ermittelt wird, beispielsweise unter Verwendung einer optischen Sensoreinrichtung mit einem Autofokus-System. Wenn die Schichtdicke der jeweiligen Isolationsschichtbereiche zerstörungsfrei ermittelt werden kann, ist dies vorteilhaft, da so noch genauer bei dem Abtragungsverfahren die freizulegende Elektrodenschicht freigelegt werden kann.

Vorteilhaft wird als Isolationsschichtmaterial ein in einem vorbestimmten Wellenlängenbereich optisch transparentes Material verwendet. Dies kann beispielsweise ein Polyimid sein. Zum Erfassen der Schichtdicke des abzutragenden Isolationsschichtbereiches wird dabei vorteilhaft eine optische Weglänge einer elektromagnetischen Strahlung mit einer Wellenlänge in dem vorbestimmten Wellenlängenbereich ermittelt. Vorteilhaft ist der Brechungsindex der elektromagnetischen Strahlung in dem bekannten Isolationsschichtmaterial bekannt, sodass man aus dem bekannten Brechungsindex und der erfassten optischen Weglänge der elektromagnetischen Strahlung die Schichtdicke der Isolationsschicht in dem vermessenen Bereich berechnen kann. Wenn das Isolationsschichtmaterial optisch transparent ist, kann nicht nur die Isolationsschichtoberfläche, sondern auch die Oberfläche eines darunter liegenden Substrates erfasst werden, und aus dieser Differenz mithilfe des bekannten Brechungsindex die Schichtdicke ermittelt werden. Wenn vorteilhaft als Sensoreinrichtung, mithilfe derer die Schichtdicke optisch ermittelt wird, ein Autofokus-System verwendet wird, können auch Unebenheiten in dem der Isolationsschicht zugrundeliegenden Substrat ausgeglichen werden.

Vorteilhaft wird als Abtragungseinrichtung zum Abtragen des abzutragenden Isolationsschichtbereiches ein Laser, insbesondere ein Ultrakurzpulslaser, bevorzugt ein Pikosekundenlaser, oder eine optische Maske verwendet. Ultrakurzpulslaser haben den Vorteil, dass aufgrund ihrer gepulsten elektromagnetischen Strahlung die Laserparameter, von denen die Abtragungsrate abhängt, recht schnell verändert und somit lokal angepasst werden können. Gleichzeitig kann der verwendete Laser auch als Sensor verwendet werden, der die elektromagnetische Strahlung ausstrahlt, mit der die Schichtdicke der Isolationsschichtbereiche vermessen werden kann.

Alternativ zu einem Laser kann auch eine modulierbare optische Maske und deren Abbildung zur Strukturierung der Isolationsschichtbereiche verwendet werden. Hierbei wird ein Intensitätsmuster durch Abbildung in Form einer Maskenprojektion erzeugt.

In vorteilhafter Ausgestaltung wird zum Abtragen des Isolationsschichtbereiches eine Scaneinrichtung zum schrittweisen Führen einer Laserstrahlung des Lasers über eine Isolationsschichtoberfläche verwendet. Dadurch ist das Abtragungsverfahren vorteilhaft ein scannendes Abtragungsverfahren, da bei jedem Schritt die Abtragungsrate des Lasers schnell moduliert wird, und so an die Schichtdicke der Isolationsschicht angepasst ist. Der lokale Abtrag kann dadurch an jeder Position eingestellt werden. Bei jedem Scanschritt ist es möglich, die Laserparameter neu an die vorhandene Schichtdicke der Isolationsschicht anzupassen, das heißt ein Laser weist eine genügend schnelle Modulationsfähigkeit der Abtragungsrate auf.

In einer besonders bevorzugten Ausgestaltung wird die Scaneinrichtung nicht nur zum Führen der Laserstrahlung des Lasers, sondern insbesondere auch zum schrittweisen Führen einer Sensoreinrichtung über die Isolationsschichtoberfläche zum Erfassen der Schichtdicke des abzutragenden Isolationsschichtbereiches verwendet. Somit kann auch die Sensoreinrichtung das Oberflächenprofil der Isolationsschicht scannend abtasten und so die Schichtdicke für jeden einzelnen Schritt ermitteln.

Vorteilhaft wird die Abtragungsrate zum Abtragen des Isolationsschichtbereiches durch Veränderung einer Laserpulszahl des Lasers pro Fläche eingestellt. Die Laserpulszahl kann beispielsweise durch eine Scangeschwindigkeit der Laserstrahlung über die Isolationsschichtoberfläche, das heißt den Vorschub der Laserstrahlung, aber auch durch eine Anzahl von Überfahrten über die gleiche Position an der Isolationsschichtoberfläche oder auch durch eine Kombination beider Möglichkeiten eingestellt werden. Alternativ wäre es auch möglich, eine Pulsenergie, eine Pulsfolgefrequenz bzw. eine Fokussierung des Lasers zu modulieren, jedoch nur unter der Voraussetzung, dass diese schnell genug erfolgen kann, dass bei jedem Scanschritt diese Parameter verändert werden können.

Die Scangeschwindigkeit der Scaneinrichtung bewegt sich vorteilhaft in einem Bereich von 1,3 m/s bis 2,0 m/s und kann in diesem Bereich variiert werden. Zusätzlich kann die Anzahl der Überfahrten über ein und dieselbe Stelle eingestellt werden, sodass insgesamt eine vorbestimmte Anzahl an Laserpulsen auf eine Stelle trifft und die Isolationsschicht entsprechend ihrer Schichtdicke an dieser Stelle abträgt.

Ein elektromechanischer Aktor (als solcher nicht Gegenstand der Erfindung), der insbesondere hergestellt ist mit dem oben beschriebenen Herstellungsverfahren, weist ein als Stapel ausgebildetes elektrisches Bauelement auf, das aus einer Mehrzahl von Piezokeramikschichten und aus einer Mehrzahl von Elektrodenschichten gebildet ist, welche entlang einer Längsachse des Stapels abwechselnd übereinander gestapelt sind. Der Stapel weist an wenigstens einer Seitenfläche eine Isolationsschicht auf. Zum Freilegen wenigstens einer Elektrodenschicht an der Seitenfläche des Stapels senkrecht zu der Längsachse des Stapels ist ein Graben gebildet, der sich vollständig durch die Isolationsschicht eines der Elektrodenschicht benachbarten Isolationsschichtbereiches und in der Elektrodenschicht benachbarten Piezokeramikschichten derart erstreckt, dass die Elektrodenschicht in den Graben hervorsteht.

So kann eine zuverlässige Kontaktierung der freigelegten Elektrodenschicht von außen durch die Isolationsschicht hindurch gewährleistet werden, wobei die vollaktiven Eigenschaften des Stapels erhalten bleiben.

Vorteilhaft weist der Graben senkrecht zu der Längsachse des Stapels schräg angeordnete Grabenwände auf, wobei sich der Graben von der Isolationsschichtoberfläche in Richtung auf eine Stapelmitte hin verjüngt. Schräg angeordnete Grabenwände haben den Vorteil, dass ein beispielsweise zur Kontaktierung gewählter Leitkleber gut von außen in den Graben hineinfließen kann und so eine vorteilhaft gute Kontaktierung der freigelegten Elektrodenschicht realisiert werden kann.

Der Graben weist in der Isolationsschicht einen ersten Grabenbereich auf. Weiter weist der Graben in Piezokeramikschichten, die entlang der Längsachse des Stapels jeweils benachbart zu der freizulegenden Elektrodenschicht angeordnet sind, einen zweiten bzw. dritten Grabenbereich auf. Die Grabenwände in dem ersten, dem zweiten und in dem dritten Grabenbereich sind jeweils senkrecht zu der Längsachse des Stapels schräg angeordnet. Insgesamt weist daher der Graben im Längsschnitt durch den Stapel vorteilhaft eine W-Form auf.

Vorteilhafte Ausgestaltungen der Erfindung werden nachfolgend anhand der beigefügten Zeichnungen näher erläutert. Darin zeigt:
- Fig. 1: eine perspektivische Darstellung eines elektromechanischen Aktors, der ein als Stapel ausgebildetes elektrisches Bauelement aufweist;
- Fig. 2: eine Längsschnittdarstellung des elektrischen Bauelementes aus Fig. 1, das an zwei sich gegenüberliegenden Seitenflächen jeweils eine Isolationsschicht aufweist;

- Fig. 3: einen Ausschnitt des elektrischen Bauelementes aus Fig. 2 im Bereich der Seitenfläche mit der Isolationsschicht;
- Fig. 4: eine Längsschnittdarstellung des elektrischen Bauelementes entsprechend Fig. 2, wobei eine Sensoreinrichtung zum Erfassen einer Schichtdicke der Isolationsschicht und ein getrennter Laser zum Abtragen von Isolationsschichtbereichen vorhanden ist;
- Fig. 5: eine Längsschnittdarstellung des elektrischen Bauelementes entsprechend Fig. 2, wobei ein Laser vorhanden ist, der sowohl als Sensoreinrichtung zum Erfassen der Schichtdicke der Isolationsschicht als auch als Abtragungseinrichtung ausgebildet ist;
- Fig. 6: eine schematische Darstellung a) eines Erfassens der Schichtdicke der Isolationsschicht und b) eines Abtragens von Isolationsschichtbereichen, zeitlich getrennt voneinander;
- Fig. 7: ein Flussdiagramm, das die Schritte, die bei dem Verfahren entsprechend Fig. 6 durchgeführt werden, schematisch darstellt;
- Fig. 8: eine Darstellung eines Erfassens der Schichtdicke und Abtragens der Isolationsschicht simultan;
- Fig. 9: ein Flussdiagramm, das die Schritte, die bei dem Verfahren entsprechend Fig. 8 durchgeführt werden, schematisch darstellt; und
- Fig. 10: eine schematische Schnittansicht, die einen aus dem Abtragungsverfahren resultierenden Graben in dem Stapel des elektrischen Bauelementes gemäß Fig. 2 darstellt.

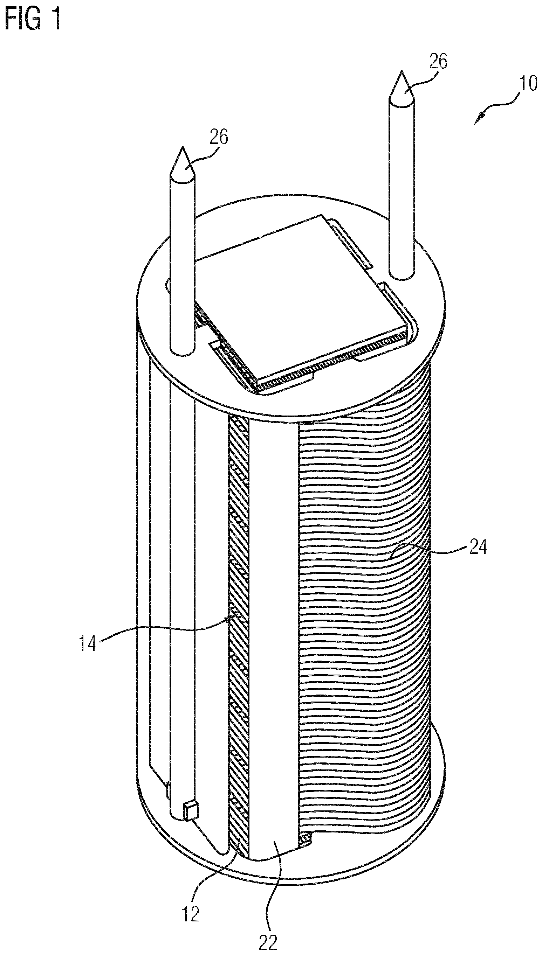

Fig. 1 zeigt einen elektromechanischen Aktor 10, der ein elektrisches Bauelement 12 aufweist, das als Stapel 14 ausgebildet ist. Eine Mehrzahl von auf Anlegen eines elektrischen Feldes reagierenden Piezokeramikschichten 16 und eine Mehrzahl von Elektrodenschichten 18 sind in dem Stapel 14 abwechselnd derart aufeinander gestapelt, dass jede Elektrodenschicht 18 zwischen zwei Piezokeramikschichten 16 angeordnet ist. Die Elektrodenschichten 18 erstrecken sich dabei vollständig bis zu allen Seitenflächen 20 des Stapels 14, sodass es sich bei dem elektrischen Bauelement 12 um einen sogenannten vollaktiven Stapel 14 handelt.

Auf einer der Seitenflächen 20 des Stapels 14 ist wenigstens eine Außenkontaktierung in Form einer Außenelektrode 22 aufgebracht, die elektrisch über ein Kontaktierungselement 24 mit einem Kontaktierungspin 26 verbunden ist. Über den Kontaktierungspin 26 und das Kontaktierungselement 24 sowie die Außenelektrode 22 kann ein elektrisches Potential an die jeweils kontaktierte Elektrodenschicht 18 weitergeleitet werden. Da jeweils zueinander benachbarte Elektrodenschichten 18 mit unterschiedlichen elektrischen Potentialen beaufschlagt werden sollen, um so ein elektrisches Feld in dem Stapel 14 zu erzeugen, damit sich die Piezokeramikschichten 16 in ihrer Länge verändern können, sind zwei Kontaktierungspins 26 vorhanden, über die jeweils ein unterschiedliches Potential an den Stapel 14 herangeführt wird.

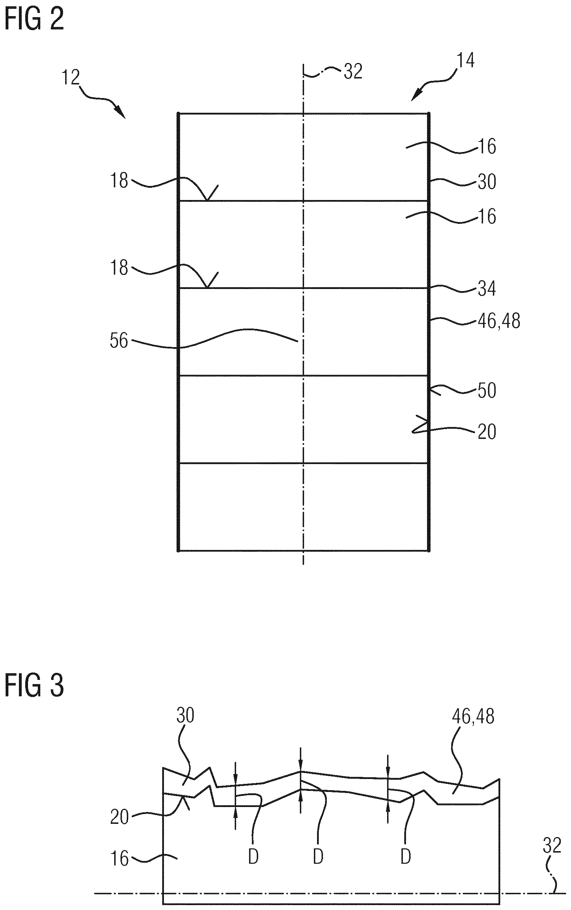

Um einen Überschlag zwischen den über die beiden Kontaktierungspins 26 aufgebrachten unterschiedlichen Potentialen zu vermeiden, wird gewöhnlich auf die Seitenflächen 20, auf die eine Außenelektrode 22 aufgebracht wird, eine Isolationsschicht 30 aufgebracht. Ein Stapel 14, der an wenigstens zwei Seitenflächen 20, die sich parallel zu einer Längsachse 32 des Stapels 14 erstrecken, eine solche Isolationsschicht 30 aufweist, ist in Fig. 2 in einer Längsschnittdarstellung entlang der Längsachse 32 des Stapels 14 aus Fig. 1 gezeigt.

Fig. 3 zeigt einen Ausschnitt aus dem Stapel 14 in Fig. 2 im Bereich der Seitenfläche 20 mit der Isolationsschicht 30 auf eine der Piezokeramikschichten 16, wobei zu sehen ist, dass eine Schichtdicke D der Isolationsschicht 30 entlang der Längsachse 32 lokal stark schwankt.

Um die Elektrodenschichten 18 von außen kontaktieren zu können, ist es nötig, die Isolationsschicht 30 in Teilbereichen, das heißt dort, wo die Elektrodenschicht 18, die jeweils kontaktiert werden soll, an die Seitenfläche 20 hervortritt, zu entfernen.

Zum Abtragen der Isolationsschicht 30 in diesen genannten Teilbereichen, nämlich lokal begrenzten Isolationsschichtbereichen 34, wird daher vorteilhaft ein Laser 36, insbesondere ein Pikosekundenlaser, verwendet, der eine Laserstrahlung 40 auf die Isolationsschicht 30 aussendet und diese somit abträgt, sodass die darunter liegende Elektrodenschicht 18 freigelegt wird. Vorteilhaft wird die Laserstrahlung 38 über ein scannendes Verfahren mithilfe einer Scaneinrichtung 40 über die Isolationsschicht 30 geführt, sodass diese bereichsweise abgetragen wird.

Um sicherzustellen, dass durch den Laser 36 nur die Schichtdicke D der Isolationsschicht 30 abgetragen wird, die in dem lokal begrenzten Isolationsschichtbereich 34 vorliegt, wird vor dem Abtragen der Isolationsschicht 30 zunächst über eine Sensoreinrichtung 42 die lokale Schichtdicke D in dem Isolationsschichtbereich 34, der abgetragen werden soll, vermessen. Die Sensoreinrichtung 42 ist vorzugsweise eine optische Sensoreinrichtung 42 mit einem Autofokus-System, die eine elektromagnetische Strahlung EM aussendet, welche ebenfalls wie die Laserstrahlung 38 über die Scaneinrichtung 40 schrittweise über die Isolationsschicht 30 auf der Seitenfläche 20 geführt wird.

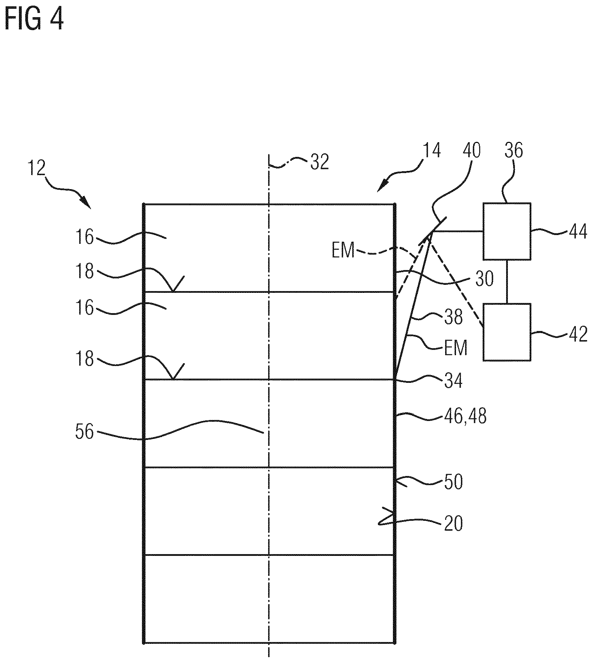

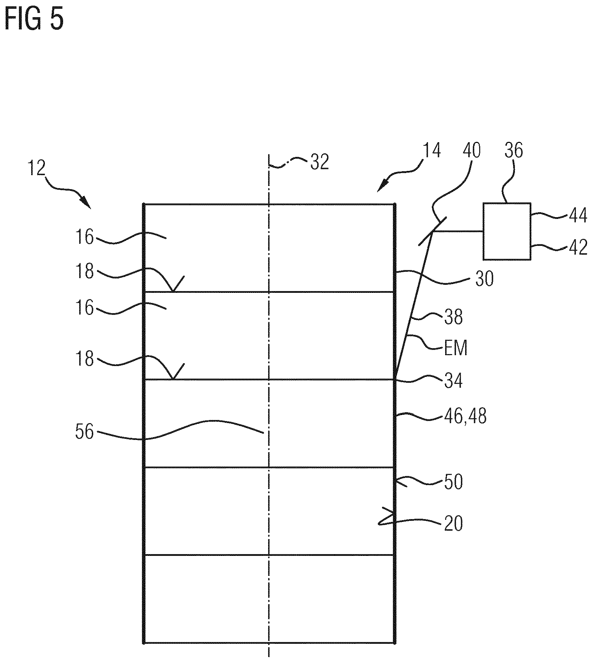

In Fig. 4 ist der Stapel 14 aus Fig. 2 zusammen mit einem Laser 36 und einer Sensoreinrichtung 42 dargestellt, die getrennt voneinander gebildet sind, und deren elektromagnetische Strahlungen EM jedoch über eine gemeinsame Scaneinrichtung 40 über die Isolationsschicht 30 auf einer der Seitenflächen 20 des Stapels 14 geführt werden. In Fig. 5 ist eine alternative Ausführungsform dargestellt, bei der der Laser 36 gleichzeitig die Sensoreinrichtung 42 sowie eine Abtragungseinrichtung 44 zum Abtragen des Isolationsschichtbereiches 34 bildet.

Das Erfassen der Schichtdicke D der Isolationsschicht 30 wird vorteilhaft zerstörungsfrei durchgeführt. Dies ist beispielsweise möglich, wenn als Isolationsschichtmaterial 46 ein optisch transparentes Material, wie beispielsweise Polyimid 48, verwendet wird. Wird dann die Wellenlänge der Laserstrahlung 38 entsprechend gewählt, kann die Laserstrahlung 38 die komplette Isolationsschicht 30 durchdringen und so auch eine Oberfläche der Piezokeramikschichten 16 bzw. der Elektrodenschichten 18 bestrahlen. Dadurch kann eine optische Weglänge der Laserstrahlung 38 in dem Isolationsschichtmaterial 46 erfasst werden, und durch den bekannten Brechungsindex dann auf die Schichtdicke D zurück gerechnet werden.

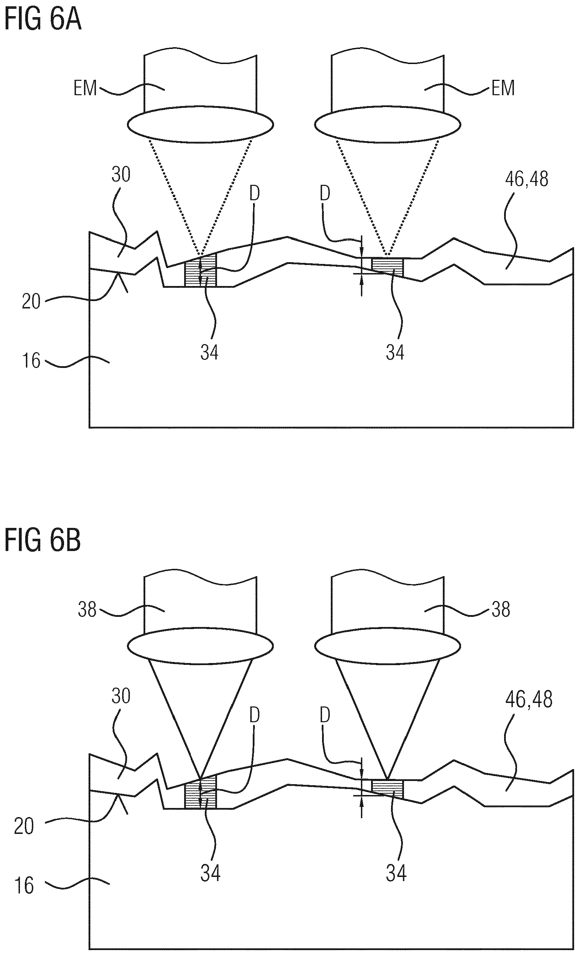

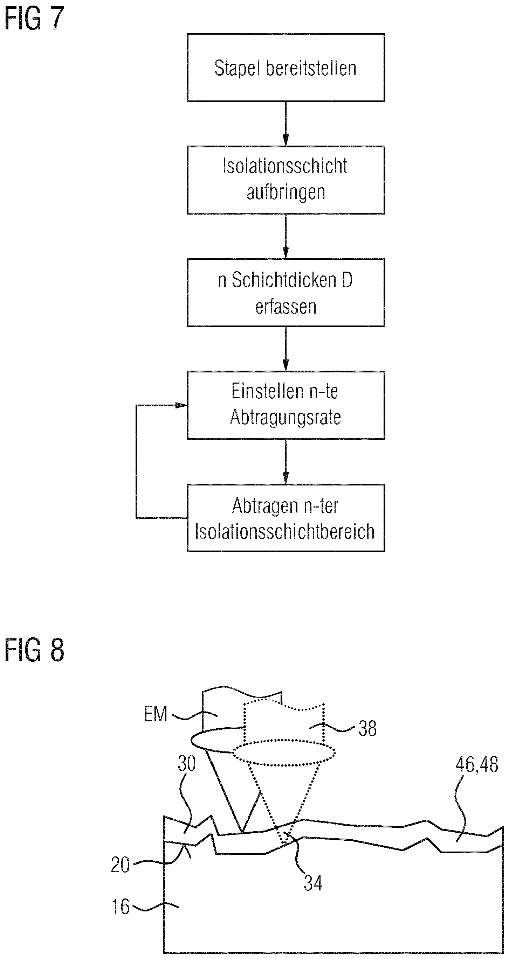

Es gibt zwei Möglichkeiten, das Erfassen der Schichtdicke D und das Abtragen der Isolationsschichtbereiche 34 durchzuführen. Einerseits ist es möglich, diese beiden Arbeitsschritte zeitlich getrennt voneinander durchzuführen, wie es beispielsweise in Fig. 6 und mit Bezug auf das Flussdiagramm in Fig. 7 dargestellt ist. Fig. 6a) zeigt dabei die Laserstrahlung 38, die, geführt über die Scaneinrichtung 40, eine Isolationsschichtoberfläche 50 zunächst vollständig abtastet, sodass die Schichtdicken D sämtlicher lokal begrenzter Isolationsschichtbereiche 34 vollständig bekannt sind. Erst in einem darauffolgenden Arbeitsschritt, dargestellt in Fig. 6b) wird dann die Laserstrahlung 38 mittels der Scaneinrichtung 40 über die Isolationsschichtoberfläche 50 schrittweise geführt, und an den jeweiligen Stellen der Isolationsschichtbereiche 34 lokal moduliert, um so die dort vorhandene Schichtdicke D der Isolationsschicht 30 abzutragen. Die lokale Modulierung erfolgt dabei über die Scangeschwindigkeit, mit der die Laserstrahlung 38 über die Isolationsschichtoberfläche 50 geführt wird. Alternativ oder zusätzlich ist es auch möglich, die Modulation durch eine verschiedene Anzahl an Überfahrten über die betreffenden Stellen zu realisieren.

Fig. 7 zeigt ein entsprechendes Flussdiagramm, das die einzelnen Schritte darstellt, die zum Freilegen der freizulegenden Elektrodenschicht 18 gemäß der Vorgehensweise, die in Fig. 6 dargestellt ist, zeigt. Zunächst wird dabei der Stapel 14 bereitgestellt und in einem nachfolgenden Schritt auf wenigstens eine Seitenfläche 20 des Stapels 14 die Isolationsschicht 30 aufgebracht. Danach wird die Isolationsschichtoberfläche 50 vollständig in n Schritten mit der Sensoreinrichtung 42 abgescannt, um so sämtliche Schichtdicken D der Isolationsschicht 30 zu erfassen. Erst nachdem die vollständige Isolationsschichtoberfläche 50 abgescannt ist, wird die Laserstrahlung 38 in n Schritten über die Isolationsschichtoberfläche 50 geführt, wobei bei jedem n-ten Schritt die Abtragungsrate der Laserstrahlung 38, das heißt die Pulszahl, eingestellt wird, und erst danach die Isolationsschicht 30 abgetragen wird. Die letzten beiden Schritte Einstellen und Abtragen für den jeweils n-ten Schritt werden dabei so lange wiederholt, bis die Isolationsschichtoberfläche 50 vollständig abgescannt ist.

In Fig. 8 ist eine alternative Vorgehensweise dargestellt, bei der das Erfassen der Schichtdicke D an den einzelnen Isolationsschichtbereichen 34 sowie das Abtragen der Isolationsschicht 30 an den Isolationsschichtbereichen 34 simultan durchgeführt wird. Hierbei wird bei jedem Scanschritt zuerst die Schichtdicke D vermessen und dann direkt das Abtragen über die Laserstrahlung 38 durchgeführt, und erst dann die elektromagnetische Strahlung EM des Lasers 36 bzw. der Sensoreinrichtung 42 auf die nächste Position geführt, wo dann ebenfalls zunächst gemessen und dann direkt abgetragen wird.

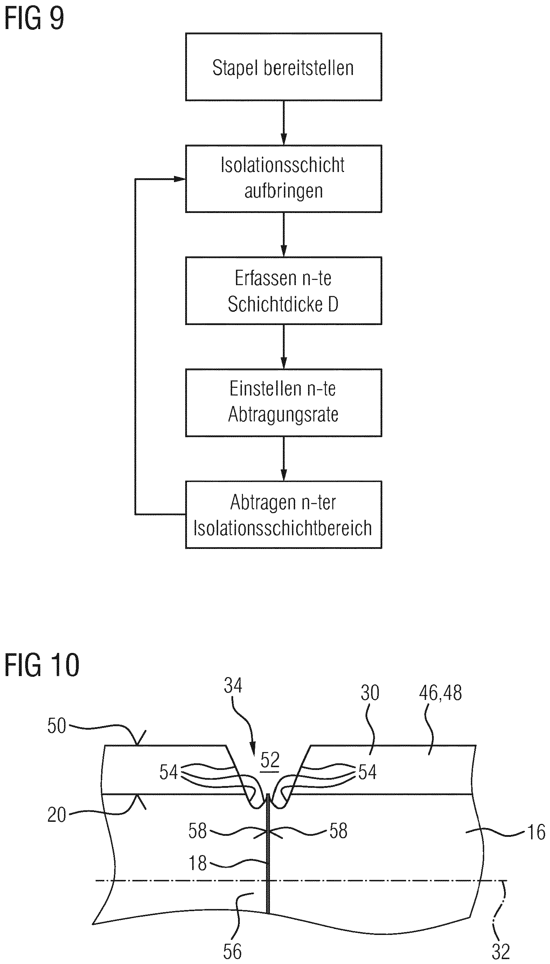

Fig. 9 zeigt ein entsprechendes Flussdiagramm, welches die Schritte einer solchen Vorgehensweise schematisch darstellt.

In einem ersten Schritt wird dabei der Stapel 14 bereitgestellt und darauf folgend in einem weiteren Schritt die Isolationsschicht 30 auf wenigstens eine Seitenfläche 20 des Stapels 14 aufgebracht. Danach wird mit der Sensoreinrichtung 42 unter Verwendung der Scaneinrichtung 40 ein erster Schritt gemacht, um einen lokal begrenzten Isolationsschichtbereich 34 gemäß seiner Schichtdicke D zu vermessen. Direkt darauf folgend wird die Abtragungsrate des Lasers 36 auf diese vermessene Schichtdicke D eingestellt und darauf folgend sofort der Isolationsschichtbereich 34, der gerade vermessen worden ist, abgetragen. Die letzten drei Schritte, Erfassen eines lokal begrenzten Bereiches, Einstellen der Abtragungsrate entsprechend des erfassten Wertes und sofortiges Abtragen, werden so lange durchgeführt, bis die gesamte Isolationsschichtoberfläche 50 abgescannt ist.

Fig. 10 zeigt einen Ausschnitt des Stapels 14 aus Fig. 2, nachdem in einem lokal begrenzten Isolationsschichtbereich 34 die Isolationsschicht 30 wie oben beschrieben abgetragen worden ist. Durch das Abtragen und damit durch das Freilegen der unter dem lokalen Isolationsschichtbereich 34 angeordneten Elektrodenschicht 18 ist ein Graben 52 entstanden, der sich vollständig durch die Isolationsschicht 30 erstreckt. Der Graben 52 erstreckt sich weiter sehr geringfügig in die der Elektrodenschicht 18 entlang der Längsachse 32 benachbarten Piezokeramikschichten 16, und zwar derart, dass die Elektrodenschicht 18 in den Graben hervorsteht. Grabenwände 54 des Grabens 52 sind senkrecht zu der Längsachse 32 des Stapels 14 schräg angeordnet, sodass sich der Graben 52 ausgehend von der Isolationsschichtoberfläche 50 auf eine Stapelmitte 56 hin verjüngt. Der Graben 52 weist mehrere Grabenbereiche auf, nämlich einen ersten Grabenbereich in der Isolationsschicht 30, und einen zweiten bzw. dritten Grabenbereich jeweils in den zu der Elektrodenschicht 18 benachbarten Piezokeramikschichten 16. Alle Grabenwände 54 der einzelnen Grabenbereiche sind senkrecht zu der Längsachse 82 schräg angeordnet. Daher kann ein beispielsweise zur Kontaktierung verwendeter Leitkleber gut in den gesamten Graben 52 einfließen und somit eine gute Kontaktierung der freigelegten Elektrodenschicht 18 realisieren.

Insgesamt weist der Graben 52 eine Form entsprechend eines W auf. Diese W-Form kann dadurch erzeugt werden, dass die Laserstrahlung 38, die die Isolationsschicht 30 in dem Isolationsschichtbereich 34 abträgt, so selektiv beispielsweise hinsichtlich ihrer Energie eingestellt wird, dass die Isolationsschicht 30 dort komplett und die Piezokeramikschichten 16 sehr geringfügig abgetragen werden. Dadurch kann das Hervorstehen der Elektrodenschicht 18 erzielt werden, wodurch eine Kontaktierung der Elektrodenschicht 18 nicht nur an der Seitenfläche 20, sondern auch an Stirnflächen 58 der Elektrodenschicht 18 realisiert werden kann, welche normalerweise von den benachbarten Piezokeramikschichten 16 bedeckt sind.

Durch Abtragen der Isolationsschicht 30 mit einem Ultrakurzpulslaser 36 und der Wahl geeigneter Laser- bzw. Scanparameter kann die Abtragungsrate präzise und schnell eingestellt werden. Wenn die lokale Schichtdicke D des Polyimids 48 bekannt ist, kann durch eine entsprechend schnelle Modulation der Laser- bzw. Scanparameter die lokale Abtragungsrate entsprechend angepasst werden und ein adaptives Abtragen realisiert werden.

## Patentansprüche

1. Herstellungsverfahren zum Herstellen eines elektromechanischen Aktors (10), aufweisend die Schritte:
a) Bereitstellen eines als Stapel (14) ausgebildeten elektrischen Bauelements (12), das aus einer Mehrzahl von Piezokeramikschichten (16) und aus einer Mehrzahl von Elektrodenschichten (18) gebildet ist, die entlang einer Längsachse (32) des Stapels (14) abwechselnd übereinander gestapelt sind;
b) Aufbringen einer Isolationsschicht (30) auf wenigstens eine parallel zu der Längsachse (32) angeordnete Seitenfläche (20) des Stapels (14) derart, dass an der Seitenfläche (20) die Elektrodenschichten (18) und die Piezokeramikschichten (16) von der Isolationsschicht (30) bedeckt sind;
c) Freilegen wenigstens einer der Elektrodenschichten (18) an der Seitenfläche (20) des Stapels (14) durch lokales Abtragen eines der freizulegenden Elektrodenschicht (18) benachbarten, lokal begrenzten Isolationsschichtbereiches (34),
wobei eine Schichtdicke (D) des abzutragenden, lokal begrenzten Isolationsschichtbereiches (34) senkrecht zu der Längsachse (32) erfasst wird, und wobei eine Abtragungsrate zum Abtragen des Isolationsschichtbereiches (34) der erfassten Schichtdicke (D) des abzutragenden Isolationsschichtbereichs (34)lokal begrenzt eingestellt wird, **dadurch gekennzeichnet, dass** die Schichtdicken (D) mehrerer lokal begrenzter Isolationsschichtbereiche (34) auf der Seitenfläche (20) schrittweise einzeln erfasst werden.

2. Herstellungsverfahren nach Anspruch 1,
**dadurch gekennzeichnet, dass** die mehreren Isolationsschichtbereiche (32) schrittweise einzeln abgetragen werden, wobei das schrittweise Erfassen und das schrittweise Abtragen der einzelnen Schichtdicken (D) unmittelbar aufeinanderfolgend durchgeführt werden.

3. Herstellungsverfahren nach Anspruch 2,
**dadurch gekennzeichnet, dass** die Schichtdicken (D) mittels Plasmaspektroskopie erfasst werden.

4. Herstellungsverfahren nach Anspruch 1,
**dadurch gekennzeichnet, dass** die mehreren Isolationsschichtbereiche (34) schrittweise abgetragen werden, wobei zunächst alle Schichtdicken (D) der mehreren Isolationsschichtbereiche (34) schrittweise ohne Abtragungsschritte dazwischen erfasst werden und dann das Abtragen der mehreren Isolationsschichtbereiche (34) schrittweise ohne Erfassungsschritte dazwischen durchgeführt wird.

5. Herstellungsverfahren nach einem der Ansprüche 1 oder 2 oder 4,
**dadurch gekennzeichnet, dass** die Schichtdicke (D) des abzutragenden Isolationsschichtbereiches (34) zerstörungsfrei erfasst wird, wobei die Schichtdicke (D) insbesondere optisch ermittelt wird, wobei bevorzugt eine optische Sensoreinrichtung (42) mit einem Autofokus-System verwendet wird.

6. Herstellungsverfahren nach Anspruch 5,
**dadurch gekennzeichnet, dass** als Isolationsschichtmaterial (46) ein in einem vorbestimmten Wellenlängenbereich optisch transparentes Material, insbesondere ein Polyimid (48), verwendet wird, wobei zum Erfassen der Schichtdicke (D) des abzutragenden Isolationsschichtbereiches (34) eine optische Weglänge einer elektromagnetischen Strahlung (EM) mit einer Wellenlänge in dem vorbestimmten Wellenlängenbereich ermittelt wird.

7. Herstellungsverfahren nach einem der Ansprüche 1 bis 6, **dadurch gekennzeichnet, dass** als Abtragungseinrichtung (44) zum Abtragen des abzutragenden Isolationsschichtbereiches (34) ein Laser (36), insbesondere ein Ultrakurzpulslaser, bevorzugt ein Pikosekundenlaser, oder eine optische Maske verwendet wird.

8. Herstellungsverfahren nach Anspruch 7,
**dadurch gekennzeichnet, dass** zum Abtragen des Isolationsschichtbereiches (34) eine Scaneinrichtung (40) zum schrittweisen Führen einer Laserstrahlung (38) des Lasers (36) über eine Isolationsschichtoberfläche (50) verwendet wird, wobei die Scaneinrichtung (40) insbesondere zum schrittweisen Führen einer Sensoreinrichtung (42) über die Isolationsschichtoberfläche (50) zum Erfassen der Schichtdicke (D) des abzutragenden Isolationsschichtbereiches (34) verwendet wird.

9. Herstellungsverfahren nach einem der Ansprüche 7 oder 8, **dadurch gekennzeichnet, dass** die Abtragungsrate zum Abtragen des Isolationsschichtbereiches (34) durch Veränderung einer Laserpulszahl des Lasers (36) pro Fläche eingestellt wird, wobei die Laserpulszahl pro Fläche insbesondere durch eine Scangeschwindigkeit der Scaneinrichtung (40) und/oder durch eine Anzahl an Überfahrten der Laserstrahlung (38) über die Isolationsschichtoberfläche (50) des abzutragenden Isolationsschichtbereiches (34) eingestellt wird.

## Claims

1. Production method for producing an electromechanical actuator (10), comprising the steps of:
a) providing an electrical component (12) which is in the form of a stack (14) and is formed from a plurality of piezoceramic layers (16) and from a plurality of electrode layers (18) which are stacked alternately one above the other along a longitudinal axis (32) of the stack (14);
b) applying an insulating layer (30) to at least one side face (20) of the stack (14), which side face is arranged parallel to the longitudinal axis (32), in such a way that, on the side face (20), the electrode layers (18) and the piezoceramic layers (16) are covered by the insulating layer (30);
c) exposing at least one of the electrode layers (18) on the side face (20) of the stack (14) by locally removing a locally limited insulating layer region (34) which is adjacent to the electrode layer (18) to be exposed,
wherein a layer thickness (D) of the locally limited insulating layer region (34) which is to be removed perpendicular to the longitudinal axis (32) is detected, and wherein a removal rate for removing the insulating layer region (34) of the detected layer thickness (D) of the insulating layer region (34) to be removed is set in a locally limited manner, **characterized in that** the layer thicknesses (D) of a plurality of locally limited insulating layer regions (34) are individually detected step-by-step on the side face (20).

2. Production method according to Claim 1, **characterized in that** the plurality of insulating layer regions (32) are individually removed step-by-step, wherein the step-by-step detection and the step-by-step removal of the individual layer thicknesses (D) are carried out immediately one after the other.

3. Production method according to Claim 2, **characterized in that** the layer thicknesses (D) are detected by means of plasma spectroscopy.

4. Production method according to Claim 1, **characterized in that** the plurality of insulating layer regions (34) are removed step-by-step, wherein initially all of the layer thicknesses (D) of the plurality of insulating layer regions (34) are detected step-by-step without removal steps therebetween, and then the removal of the plurality of insulating layer regions (34) is carried out step-by-step without detection steps therebetween.

5. Production method according to one of Claims 1 and 2 and 4,
**characterized in that** the layer thickness (D) of the insulating layer region (34) which is to be removed is detected without being destroyed, wherein the layer thickness (D) is, in particular, optically ascertained, wherein an optical sensor device (42) with an autofocus system is preferably used.

6. Production method according to Claim 5, **characterized in that** a material which is optically transparent in a predetermined wavelength range, in particular a polyimide (48), is used as insulating layer material (46), wherein an optical path length of electromagnetic radiation (EM) with a wavelength in the predetermined wavelength range is ascertained for the purpose of detecting the layer thickness (D) of the insulating layer region (34) which is to be removed.

7. Production method according to one of Claims 1 to 6,
**characterized in that** a laser (36), in particular an ultra short-pulse laser, preferably a picosecond laser, or an optical mask is used as the removal device (44) for removing the insulating layer region (34) which is to be removed.

8. Production method according to Claim 7, **characterized in that** a scanning device (40) for guiding a laser beam (38) of the laser (36) over an insulating layer surface (50) step-by-step is used for removing the insulating layer region (34), wherein the scanning device (40) is used, in particular, for guiding a sensor device (42) over the insulating layer surface (50) step-by-step for detecting the layer thickness (D) of the insulating layer region (34) which is to be removed.

9. Production method according to either of Claims 7 and 8,
**characterized in that** the removal rate for removing the insulating layer region (34) is set by changing a number of laser pulses of the laser (36) per unit area, wherein the number of laser pulses per unit area is set, in particular, by a scanning rate of the scanning device (40) and/or by a number of movements of the laser radiation (38) over the insulating layer surface (50) of the insulating layer region (34) which is to be removed.

## Revendications

1. Procédé de fabrication d'un actionneur électromécanique (10), le procédé comprenant les étapes suivantes :
a) fourniture d'un composant électrique (12) qui est conçu comme un empilement (14) et qui est formé d'une pluralité de couches piézo-céramiques (16) et d'une pluralité de couches d'électrode (18) qui sont empilées les unes sur les autres de manière alternée le long d'un axe longitudinal (32) de l'empilement (14) ;
b) appliquer une couche isolante (30) sur au moins une surface latérale (20) de l'empilement (14) qui est disposée parallèlement à l'axe longitudinal (32) de telle sorte que les couches d'électrode (18) et les couches piézo-céramiques (16) soient recouvertes sur la surface latérale (20) par la couche isolante (30) ;
c) exposer au moins une des couches d'électrode (18) sur la surface latérale (20) de l'empilement (14) par retrait local d'une zone de couche isolante (34) localement délimitée et adjacente à la couche d'électrode (18) à exposer,
une épaisseur de couche (D) de la zone de couche isolante (34) délimitée localement à retirer étant détectée perpendiculairement à l'axe longitudinal (32), et un taux de retrait de la zone de couche isolante (34) de l'épaisseur de couche détectée (D) de la zone de couche isolante (34) à retirer étant réglé de manière limitée localement, **caractérisé en ce que** les épaisseurs de couche (D) de plusieurs zones de couche isolante (34) localement délimitées peuvent être détectées individuellement de manière progressive sur la surface latérale (20).

2. Procédé de fabrication selon la revendication 1,
**caractérisé en ce que** la pluralité de zones de couche isolante (32) est retirée individuellement de manière progressive, la détection progressive et le retrait progressif des épaisseurs de couche individuelles (D) étant effectués directement l'un après l'autre.

3. Procédé de fabrication selon la revendication 2,
**caractérisé en ce que** les épaisseurs de couche (D) sont détectées par spectroscopie à plasma.

4. Procédé de fabrication selon la revendication 1,
**caractérisé en ce que** la pluralité de zones de couche isolante (34) sont retirées progressivement, toutes les épaisseurs de couche (D) de la pluralité de zones de couche isolante (34) étant d'abord détectées progressivement sans aucune étape de retrait intermédiaire, puis le retrait de la pluralité de zones de couche isolante (34) étant effectué progressivement sans étape de détection intermédiaire.

5. Procédé de fabrication selon l'une des revendications 1 ou 2 ou 4,
**caractérisé en ce que** l'épaisseur de couche (D) de la zone de couche isolante (34) à retirer est détectée de manière non destructive, l'épaisseur de couche (D) étant déterminée en particulier optiquement, un dispositif de détection optique (42) comprenant un système de mise au point automatique étant de préférence utilisé.

6. Procédé de fabrication selon la revendication 5,
**caractérisé en ce qu'**un matériau optiquement transparent dans une gamme de longueurs d'onde prédéterminée, en particulier un polyimide (48), est utilisé comme matériau de couche isolante (46), une longueur de trajet optique d'un rayonnement électromagnétique (EM) d'une longueur d'onde dans la gamme de longueurs d'onde prédéterminée étant déterminée afin de détecter l'épaisseur de couche (D) de la zone de couche isolante (34) à retirer.

7. Procédé de fabrication selon l'une des revendications 1 à 6, **caractérisé en ce qu'**un laser (36), notamment un laser à impulsions ultracourtes, de préférence un laser picoseconde, ou un masque optique est utilisé comme dispositif de retrait (44) destiné à retirer la zone de couche isolante (34) à retirer.

8. Procédé de fabrication selon la revendication 7, **caractérisé en ce qu'**un dispositif de balayage (40) destiné à guider progressivement un rayonnement laser (38) du laser (36) sur une surface de couche isolante (50) est utilisé pour retirer la zone de couche isolante (34), le dispositif de balayage (40) étant utilisé en particulier pour guider progressivement un dispositif de détection (42) sur la surface de couche isolante (50) afin de détecter l'épaisseur de couche (D) de la zone de couche isolante (34) à retirer.

9. Procédé de fabrication selon l'une des revendications 7 ou 8, **caractérisé en ce que** le taux de retrait de la zone de couche isolante (34) est réglé par variation d'un nombre d'impulsions laser du laser (36) par unité de surface, le nombre d'impulsions laser par unité de surface étant défini en particulier par une vitesse de balayage du dispositif de balayage (40) et/ou par un nombre de passages du rayonnement laser (38) sur la surface de couche isolante (50) de la zone de couche isolante (34) à retirer.
